(19) Europäisches Patentamt
European Patent Office
Office européen des brevets

(11) **EP 3 764 540 A1**

(12) **EUROPEAN PATENT APPLICATION**
published in accordance with Art. 153(4) EPC

(43) Date of publication:
**13.01.2021 Bulletin 2021/02**

(51) Int Cl.:
**H02S 50/10** (2014.01)

(21) Application number: **19733091.3**

(86) International application number:
**PCT/ES2019/070133**

(22) Date of filing: **06.03.2019**

(87) International publication number:
**WO 2019/170949 (12.09.2019 Gazette 2019/37)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **07.03.2018 ES 201830221**

(71) Applicant: **Universidad Politécnica De Madrid**
**28040 Madrid (ES)**

(72) Inventors:
• **LORENZO PIGUEIRAS, Eduardo**
**28040 Madrid (ES)**
• **NARVARTE FERNÁNDEZ, Luis**
**28040 Madrid (ES)**
• **MARTÍNEZ MORENO, Francisco**
**28040 Madrid (ES)**
• **CARRILLO SALINAS, José Manuel**
**28040 Madrid (ES)**

(74) Representative: **Ungria López, Javier**
**Avda. Ramón y Cajal, 78**
**28043 Madrid (ES)**

(54) **METHOD AND DEVICE FOR ESTIMATING EQUIVALENT TEMPERATURE IN PHOTOVOLTAIC MODULES**

(57) The invention relates to a method and device for estimating equivalent temperature in photovoltaic modules at random test conditions (different than the standard test conditions for photovoltaic modules). The equivalent temperature obtained by means of the method and the device of the invention can be used, together with a current intensity vs. voltage curve obtained at said random test conditions, to obtain/extrapolate the electrical characteristics (current intensity vs. voltage curve) of a photovoltaic module at standard test conditions with very low uncertainty.

FIG.1

**Description**

**Object of the invention**

The present invention relates to a method for estimating equivalent temperature in photovoltaic modules for the characterization thereof in real sunlight with low uncertainty, in its own location thereof.

The present invention also relates to the device for estimating equivalent temperature in photovoltaic modules by means of which the aforementioned method can be implemented.

The method and the device for estimating equivalent temperature in photovoltaic modules object of the present invention are applicable to the field of the industry dedicated to the design, management and maintenance of photovoltaic panels.

**Technical problem to be resolved and Background of the invention**

Photovoltaic generators are made up of multiple photovoltaic modules connected in series and in parallel, in order to achieve the power, voltage and current levels required by the applications for which they provide electrical energy.

The electrical behaviour of the generators and of the modules that form them is characterised by their electrical response to the so-called Standard Test Conditions (STC).

These Standard Test Conditions are equivalent to:

Irradiance: 1,000 W/m$^2$;
Spectral distribution: AM 1.5;
Angle of incidence of solar rays: perpendicular to the surface of the module;
Cell temperature: 25 °C.

Normally, the electrical response is understood as the I-V curve (current intensity vs. voltage) in the first quadrant (positive voltages and current), and the most relevant characteristics, such as the short-circuit current, the open-circuit voltage and the power at the maximum power point, are derived from this response.

The standard method for measuring the I-V curve at STC consists of using solar simulators, which are sets of equipment able to precisely impose the STC conditions, such that if they are calibrated correctly, they produce results with low uncertainty.

Module manufacturing plants as well as labs specialised in photovoltaic technology have solar simulators among their equipment. From the I-V curve thus measured, the characteristic values of some particularly relevant parameters are determined, such as the maximum power delivered by the module at STC, which shall be called $P^*_M$, wherein "M" indicates maximum and "*" indicates standard test conditions (STC).

Alternatively to provoking the standard test conditions (STC) by means of solar simulators, in principle it is also possible to measure the electrical response in real sunlight, meaning, in any operating condition (irradiance ≠ 1,000 W/m$^2$; spectrum ≠ AM 1.5; angle of incidence other than perpendicular and a cell temperature different than 25 °C) and subsequently correcting the response thus measured at STC. A particularly simple way to do this consists of simultaneously measuring the I-V curves of the module to be characterised and of another module with electrical response characteristics at STC which are well-known beforehand (for example, because they have been previously measured in a solar simulator) and which act as a reference, taking care that both modules are coplanar. Therefore, starting from the assumption that both modules receive the same solar irradiance and that both work at the same temperature, the electrical characteristics at STC of the first module can be estimated. For example, limiting ourselves to the power, these assumptions are translated into:

$$P^*_{M,C} = \frac{P_{M,C}}{P_{M,R}} \times P^*_{M,R} \quad \text{[Equation 1]}$$

Wherein the subscripts "C" and "R" indicate, respectively, the module to be characterised and the module acting as a reference.

Another way to obtain the electrical characteristic at STC of a photovoltaic module starting from measurements in real sunlight, this time without needing to use a reference module, consists of directly correcting the I-V curve measured in the module to be characterised by means of a mathematical process such as, for example, the one prescribed in standard IEC 60891.

However, and completely independent of the manner chosen, this way of measuring in real sunlight always involves additional uncertainty due to the difficulties of estimating the operating conditions in real sunlight which, in one way or another, are always present in that correction.

For the purpose of estimating the equivalent operating temperature of the photovoltaic module in real sunlight, it must be noted that, on one hand, the temperature of the module is not homogeneous, neither throughout one same module (the temperature varies from one cell of the module to another) nor throughout one same generator (which makes it so there is no one point where a representative temperature of the thermal behaviour of the assembly of the module can be measured) and, moreover, the encapsulation itself of the photovoltaic modules hinders measuring that temperature directly.

Thus the elevated uncertainty of direct measurements in real sunlight and subsequent correction at STC makes it so that, currently, periodic measurement campaigns of samples of modules, envisaged in many processes for ensuring technical quality of the photovoltaic plants, are mostly performed with solar simulators. This either requires the modules to be moved to a specialised laboratory equipped with said equipment, or a portable solar simulator must be moved to the photovoltaic plant like the one described in WO 2014/083212 A1. In both cases, this manner of measuring requires disassembling the modules of the location where they normally operate, before they are carried to the simulator, and reassembling them once they have been measured. This handling is frankly inconvenient since, in addition to being expensive in time and labour, they represent a significant risk for the physical integrity of the modules. More specifically, this handling is likely to create cracks in the solar cells which, in turn, can turn into hot points which affect the lifespan of the modules.

The objective technical problem presented, therefore, is that of providing a method and means for measuring in order to characterize the electrical behaviour at STC of a photovoltaic module (or group of modules), starting from measurements in real sunlight, without needing to disassemble it at its original location such that the resulting uncertainty is as low as the one corresponding to measurements performed in solar simulators.

**Description of the invention**

With the object of providing a solution to the aforementioned problems, the following method and device for estimating equivalent temperature in photovoltaic modules are presented.

The method for estimating equivalent temperature in photovoltaic modules object of the present invention comprises the following steps:

- performing, simultaneously and at random test conditions, the following measurements:

  ○ current intensity vs. voltage curve of a reference photovoltaic module, of which the current intensity vs. voltage curve thereof is known at standard test conditions;
  ○ current intensity vs. voltage curve of at least one first test photovoltaic module, from which the electrical characteristics thereof at standard test conditions are to be obtained;
  ○ temperature of a specific area of the reference photovoltaic module and of the at least one first test photovoltaic module;

- estimating the equivalent temperature of the reference photovoltaic module by means of the following expression:

$$T_{eq,R} = T^*_{eq,R} + \left( \frac{V_{0\,R}}{V^*_{0\,R}} - 1 \right) \times \beta^{-1} \quad \text{[Equation 2]}$$

wherein

$T_{eq,R}$ is the equivalent temperature of the reference photovoltaic module at the mentioned random test conditions;

$T^*_{eq,R}$ is the equivalent temperature of the reference photovoltaic module at standard test conditions (typically 25 °C);

$V_{0\,R}$ is the open-circuit voltage of the reference photovoltaic module obtained from the current intensity vs. voltage curve at the mentioned random test conditions;

$V^*_{0\,R}$ is the open-circuit voltage of the reference photovoltaic module obtained from the current intensity vs. voltage curve at standard test conditions; the value $V^*_{0\,R}$ of the reference photovoltaic module is known beforehand and is not the object of calculation of the present invention.

$\beta$ is a predetermined temperature coefficient of the reference photovoltaic module (typically associated with $V_{0\,R}^{*}$ ); the value $\beta$ of the reference photovoltaic module is known beforehand and is not the object of calculation of the present invention.

Thus, deriving the temperature of the module from the open-circuit voltage thereof is a way of compensating the temperature dispersion throughout the very module and results, for this reason, in lower uncertainty than directly measuring the temperature at one point.

- estimating the equivalent temperature of the at least one first test photovoltaic module by means of the following expression:

$$T_{eq,C} = T_{eq,R} + \left(T_{Z,C} - T_{Z,R}\right) \qquad \text{[Equation 3]}$$

wherein

$T_{eq,C}$ is the equivalent temperature of the at least one first test photovoltaic module at the mentioned random test conditions;
$T_{Z,C}$ is the temperature measured from a specific area of the at least one first test photovoltaic module;
$T_{Z,R}$ is the temperature measured from a specific area of the reference photovoltaic module.

The difference in temperature between areas enables the temperature dispersion throughout the generator to be compensated which translates into minimising uncertainty.
Preferably, the method for estimating equivalent temperature in photovoltaic modules comprises using at least one infrared-pointer temperature sensor to measure the temperature of a specific area of the reference photovoltaic module and of the at least one first test photovoltaic module.
More preferably, the method of the invention comprises focusing, respectively, each of the mentioned infrared pointers on the centre of the rear face of each photovoltaic module.
In any case, preferably, the specific area of the reference photovoltaic module and of the at least one first test photovoltaic module where the temperature is measured, is an area of said photovoltaic modules that is accessible and free of obstacles in a permanent work location of said modules.
According to a possible embodiment, the method of the invention comprises associating an effective solar irradiance value to the estimated equivalent temperatures of the reference photovoltaic module and of the at least one first test photovoltaic module.
Said effective solar irradiance is calculated starting from the current intensity vs. voltage curve of the reference photovoltaic module at the mentioned random test conditions, and depending on the current intensity vs. voltage curve of the reference photovoltaic module at the standard test conditions, by means of the following expression:

$$G = G^* \times \frac{I_{SC,R}}{I_{SC,R}^*} \qquad \text{[Equation 4]}$$

wherein

$G$ is the effective solar irradiance to be associated with the estimated equivalent temperatures of the reference photovoltaic module and of the at least one first test photovoltaic module;
$G^*$ is the effective solar irradiance associated with the standard test conditions;
$I_{SC,R}^*$ is the short-circuit current intensity of the reference photovoltaic module obtained from the current intensity vs. voltage curve at standard test conditions;
$I_{SC,R}$ is the short-circuit current intensity of the reference photovoltaic module obtained from the current intensity vs. voltage curve at the mentioned random test conditions.

As mentioned, the present invention also relates to a device for estimating equivalent temperature in photovoltaic modules.
The device for estimating equivalent temperature in photovoltaic modules object of the present invention includes:

- a first set of equipment for tracing current intensity vs. voltage curves, configured to measure the current intensity vs. voltage curve of a reference photovoltaic module at random test conditions;
- at least one second set of equipment for tracing current intensity vs. voltage curves, configured to measure the current intensity vs. voltage curve of at least one first test photovoltaic module at random test conditions;
- a first device for measuring temperature, configured to measure a temperature in an area of the reference photovoltaic module;
- at least one second device for measuring temperature, configured to measure a temperature in an area of the at least one first test photovoltaic module;
- synchronisation means of the sets of equipment for tracing current intensity vs. voltage curves, and;
- processing means configured to estimate the equivalent temperature of the reference photovoltaic module and of the at least one first test photovoltaic module at the mentioned random test conditions. Preferably, at least one of the two devices for measuring temperature is an infrared-pointer temperature sensor.

According to a possible embodiment, the sets of equipment for tracing current intensity vs. voltage curves have capacitive loads, optionally with the same load capacity as each other.

Likewise, the synchronisation means can include a button, configured to send a simultaneous firing signal to the modules for registering current intensity vs. voltage curves.

According to a specific embodiment of the device of the invention, the processing means are configured to calculate an effective solar irradiance value associated with the estimated equivalent temperatures of the reference photovoltaic module and of the at least one first test photovoltaic module.

Additionally, according to a possible embodiment of the device, the processing means are configured to calculate the electrical characteristics of the at least one first test photovoltaic module at standard test conditions, starting from the current intensity vs. voltage curve obtained (at the mentioned random test conditions)of said at least one first test photovoltaic module and starting from the estimated equivalent temperature (at the mentioned random test conditions) of said at least one first test photovoltaic module.

Likewise, according to a possible embodiment, the processing means are configured to calculate the electrical characteristics of the at least one first test photovoltaic module at standard test conditions, being based on the effective solar irradiance value associated with the estimated equivalent temperature of the test photovoltaic module.

Once the current intensity vs. voltage curve has been obtained at the random test conditions and once the equivalent temperature of the at least one first test photovoltaic module is obtained at the random test conditions, the electrical characteristics of the at least one first test photovoltaic module can be obtained as prescribed in standard IEC 60891.

Alternatively, the electrical characteristics of the at least one first test photovoltaic module can be obtained starting from [Equation 1] indicated above, but adding a correction factor to it which takes into account the described manner of calculating the equivalent temperature of the photovoltaic module, as described by the following equation:

$$P_{M,C}^{*} = \frac{P_{M,C}}{P_{M,R}} \times P_{M,R}^{*} \times \frac{[1 + \gamma \times (T_{eq,R} - T_{eq,R}^{*})]}{[1 + \gamma \times (T_{eq,C} - T_{eq,C}^{*})]} \quad \text{[Equation 5]}$$

wherein $T_{eq,R}^{*} = T_{eq,C}^{*}$, which is equal to the temperature at the standard test conditions (typically 25 °C), and wherein the gamma coefficient "$\gamma$" is the coefficient of variation of the power of the photovoltaic module with the temperature, which is known beforehand and is not the object of calculation of the present invention.

**Brief description of the figures**

As a part of the explanation of at least one preferred embodiment of the method and the device for estimating equivalent temperature in photovoltaic modules, the following figure has been included, which by way of illustration and not limitation represents the following.

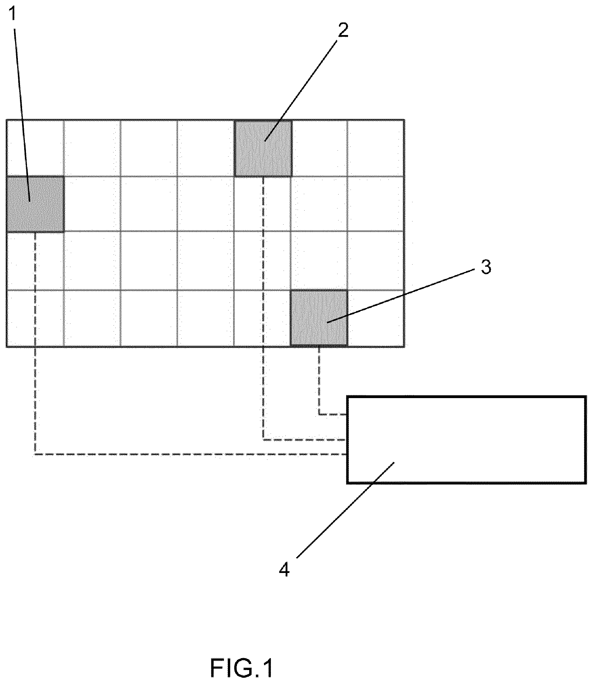

Figure 1: Shows a set of photovoltaic modules arranged in one same plane, which make up a photovoltaic generator, and with a device for simultaneously measuring the I-V curves of three modules and of the temperatures of the centre of the rear face thereof.

**Detailed description**

The present invention relates, as mentioned previously, to a method and a device for estimating equivalent temperature in photovoltaic modules.

Figure 1 shows a diagram of a photovoltaic generator made up of multiple modules, including a reference photovoltaic module (1), the characteristics of which at standard test conditions (STC) are well-known beforehand and which will act as a reference, and a first test photovoltaic module (2) and a second test photovoltaic module (3), the characteristics of which at STC are to be determined.

Beforehand, the operations of the generator are interrupted, such that current does not circulate through it, and the connections to the three photovoltaic modules (1, 2, 3) are opened, such that the respective poles (positive and negative poles of each module) can be accessed.

The measuring device (4) (represented only by a box in Figure 1) is made up of three identical I-V curve tracers (current intensity vs. voltage curves) (for example, capacitive loads with the same load capacity) which are connected to the respective modules thereof, and three temperature sensors (for example, infrared (IR) pointers which are each focused on the centre of the rear face of each of the modules).

Generally, there are as many curve tracers and as many temperature sensors as test photovoltaic modules plus one (for the reference photovoltaic module).

The measuring device (4) also includes synchronisation means (for example, a button which sends a single firing signal to the switches of the three capacitive loads) which enables both the I-V curves of the three photovoltaic modules (1, 2, 3) and the temperatures observed in the respective centres of the rear faces thereof to be registered simultaneously.

Finally, the device (4) includes processing means (a microprocessor or similar device) wherein the algorithm/method is implemented for estimating with low uncertainty the equivalent temperature of the photovoltaic modules (1, 2, 3) to be measured.

The application of this algorithm is followed by the application of another algorithm (for example, the one described by [Equation 5], the one prescribed in standard IEC 60891 or any other one with the same purpose) to transfer the measured I-V curves of the test photovoltaic modules (2, 3) at STC, which is the context wherein the algorithm for estimating temperature object of the present invention shows the utility thereof, by minimising the uncertainty associated with the transfer.

The overall method thereof includes the following steps:

- Determining the effective irradiance on the reference photovoltaic module (1) starting from the value of the short-circuit current obtained from the I-V curve of this module. Supposing that this irradiance is the same as that of the first test photovoltaic module (2) to be characterised. By way of example, the method for determining the effective irradiance can be described by [Equation 4].

- Determining the equivalent temperatures $T_{eq,R}$, $T_{eq,C}$, of the reference photovoltaic module (1) and of the first test photovoltaic module (2). To do so:

  ◦ Determining the equivalent temperature, $T_{eq,R}$, of the reference photovoltaic module (1) starting from the open-circuit voltage, $V_{0\,R}$, obtained from the I-V curve of this module, for example, by means of [Equation 2].
  ◦ Determining the equivalent temperature, $T_{eq,C}$, of the first test photovoltaic module (2) by supposing that the equivalent temperature results from correcting that of the reference photovoltaic module (1) with the difference between the temperatures observed in the centres of the back faces of the reference photovoltaic module (1) and of the first test photovoltaic module (2) according to [Equation 3].

- Correcting the I-V curve of the first test photovoltaic module (2) at STC, following the provisions of standard IEC 60891 or any other similar method, taking the temperature calculated in the previous step as the equivalent temperature.

- Extracting the characteristics at STC of the first test photovoltaic module (2) (maximum power, short-circuit current and open-circuit voltage) starting from the curve corrected in this manner. By way of example, [Equation 5] enables this step and the previous one to be performed together.

- Repeating the method described in the previous points for the second test photovoltaic module (3).

## Claims

1. A method for estimating equivalent temperature in photovoltaic modules that comprises:

   - performing, simultaneously and at random test conditions, the following measurements:

     ◦ current intensity vs. voltage curve of a reference photovoltaic module (1), of which the current intensity vs. voltage curve thereof is known at standard test conditions;

◦ current intensity vs. voltage curve of at least one first test photovoltaic module (2), from which the electrical characteristics thereof at standard test conditions are to be obtained;
◦ temperature of a specific area of the reference photovoltaic module (1) and of the at least one first test photovoltaic module (2);

- estimating the equivalent temperature of the reference photovoltaic module (1) by means of the following expression:

$$T_{eq,R} = T^*_{eq,R} + \left( \frac{V_{0\,R}}{V^*_{0\,R}} - 1 \right) \times \beta^{-1}$$

wherein

$T_{eq,R}$ is the equivalent temperature of the reference photovoltaic module (1) at the mentioned random test conditions;
$T^*_{eq,R}$ is the equivalent temperature of the reference photovoltaic module (1) at standard test conditions;
$V_{0\,R}$ is the open-circuit voltage of the reference photovoltaic module (1) obtained from the current intensity vs. voltage curve at the mentioned random test conditions;

$V^*_{0\,R}$ is the open-circuit voltage of the reference photovoltaic module (1) obtained from the current intensity vs. voltage curve at standard test conditions;
$\beta$ is a predetermined temperature coefficient of the reference photovoltaic module (1);
**characterized in that** it comprises

- estimating the equivalent temperature of the at least one first test photovoltaic module (2) by means of the following expression:

$$T_{eq,C} = T_{eq,R} + \left( T_{Z,C} - T_{Z,R} \right)$$

wherein

$T_{eq,C}$ is the equivalent temperature of the at least one first test photovoltaic module (2) at the mentioned random test conditions;
$T_{Z,C}$ is the measured temperature of a specific area of the at least one first test photovoltaic module (2);
$T_{Z,R}$ is the measured temperature of a specific area of the reference photovoltaic module (1).

2. The method for estimating equivalent temperature in photovoltaic modules according to claim 1, **wherein** it comprises using at least one infrared-pointer temperature sensor to measure the temperature of a specific area of the reference photovoltaic module (1) and of the at least one first test photovoltaic module (2).

3. The method for estimating equivalent temperature in photovoltaic modules according to claim 2, **wherein** it comprises focusing, respectively, each of the infrared pointers on the centre of the back face of each photovoltaic module.

4. The method for estimating equivalent temperature in photovoltaic modules according to any of the preceding claims, **wherein** the specific area of the reference photovoltaic module (1) and of the at least one first test photovoltaic module (2) where the temperature is measured, is an area of said photovoltaic modules that is accessible and free of obstacles in a permanent work location of said modules.

5. The method for estimating equivalent temperature in photovoltaic modules according to any of the preceding claims, **wherein** it comprises associating an effective solar irradiance with the estimated equivalent temperatures of the reference photovoltaic module (1) and of the at least one first test photovoltaic module (2), wherein said effective solar irradiance is calculated starting from the current intensity vs. voltage curve of the reference photovoltaic module (1) at the mentioned random test conditions, and depending on the current intensity vs. voltage curve of the reference photovoltaic module (1) at standard test conditions, by means of the following expression:

$$G = G^* \times \frac{I_{SC,R}}{I^*_{SC,R}}$$

wherein

$G$ is the effective solar irradiance to be associated with the estimated equivalent temperatures of the reference photovoltaic module (1) and of the at least one first test photovoltaic module (2);

$G^*$ is the effective solar irradiance associated with the standard test conditions;

$I^*_{SC,R}$ is the short-circuit current intensity of the reference photovoltaic module (1) obtained from the current intensity vs. voltage curve at standard test conditions;

$I_{SC,R}$ is the short-circuit current intensity of the reference photovoltaic module (1) obtained from the current intensity vs. voltage curve at the mentioned random test conditions.

**6.** A device (4) for estimating equivalent temperature in photovoltaic modules **characterised in that** it comprises:

- a first set of equipment for tracing current intensity vs. voltage curves, configured to measure the current intensity vs. voltage curve of a reference photovoltaic module (1) at random test conditions;
- at least one second set of equipment for tracing current intensity vs. voltage curves, configured to measure the current intensity vs. voltage curve of at least one first test photovoltaic module (2) at random test conditions;
- a first device for measuring temperature, configured to measure a temperature in an area of the reference photovoltaic module (1);
- at least one second device for measuring temperature, configured to measure a temperature in an area of the at least one first test photovoltaic module (2);
- synchronisation means of the modules for registering current intensity vs. voltage curves, and;
- processing means configured to estimate the equivalent temperature of the reference photovoltaic module (1) and of the at least one first test photovoltaic module (2) at the mentioned random test conditions.

**7.** The device for estimating equivalent temperature in photovoltaic modules according to claim 5, **wherein** at least one of the modules for measuring temperature is an infrared-pointer temperature sensor.

**8.** The device for estimating equivalent temperature in photovoltaic modules according to any of claims 6 or 7, **wherein** the modules for registering current intensity vs. voltage curves are capacitive loads.

**9.** The device for estimating equivalent temperature in photovoltaic modules according to any of claims 6 to 8, **wherein** the synchronisation means comprise a button, configured to send a simultaneous firing signal to the sets of equipment for tracing current intensity vs. voltage curves.

**10.** The device for estimating equivalent temperature in photovoltaic modules according to any of claims 6 to 9, **wherein** the processing means are configured to estimate the equivalent temperature of the reference photovoltaic module (1), by means of the following expression:

$$T_{eq,R} = T^*_{eq,R} + \left( \frac{V_{0\,R}}{V^*_{0\,R}} - 1 \right) \times \beta^{-1}$$

wherein

$T_{eq,R}$ is the equivalent temperature of the reference photovoltaic module at the mentioned random test conditions;

$T^*_{eq,R}$ is the equivalent temperature of the reference photovoltaic module at standard test conditions (typically 25 °C);

$V_{0\,R}$ is the open-circuit voltage of the reference photovoltaic module obtained from the current intensity vs. voltage curve at the mentioned random test conditions;

$V^*_{0\,R}$ is the open-circuit voltage of the reference photovoltaic module obtained from the current intensity vs. voltage curve at standard test conditions;

$\beta$ is a predetermined temperature coefficient of the reference photovoltaic module (1);

and wherein the processing means are configured to estimate the equivalent temperature of the at least one first test photovoltaic module (2) by means of the following expression:

$$T_{eq,C} = T_{eq,R} + \left( T_{Z,C} - T_{Z,R} \right)$$

wherein

$T_{eq,C}$ is the equivalent temperature of the at least one first test photovoltaic module at the mentioned random test conditions;

$T_{Z,C}$ is the temperature measured from a specific area of the at least one first test photovoltaic module (2);

$T_{Z,R}$ is the temperature measured from a specific area of the reference photovoltaic module (1).

11. The device for estimating equivalent temperature in photovoltaic modules according to any of claims 6 to 10, **wherein** the processing means are configured to calculate an effective solar irradiance value associated with the estimated equivalent temperatures of the reference photovoltaic module (1) and of the at least one first test photovoltaic module (2), wherein said calculation is made by means of the following expression:

$$G = G^{*} \times \frac{I_{SC,R}}{I_{SC,R}^{*}}$$

wherein

$G$ is the effective solar irradiance to be associated with the estimated equivalent temperatures of the reference photovoltaic module (1) and of the at least one first test photovoltaic module (2);

$G^{*}$ is the effective solar irradiance associated with the standard test conditions;

$I_{SC,R}^{*}$ is the short-circuit current intensity of the reference photovoltaic module (1) obtained from the current intensity vs. voltage curve at standard test conditions;

$I_{SC,R}$ is the short-circuit current intensity of the reference photovoltaic module (1) obtained from the current intensity vs. voltage curve at the mentioned random test conditions.

12. The device for estimating equivalent temperature in photovoltaic modules according to any of claims 6 to 11, **wherein** the processing means are configured to calculate the electrical characteristics of the at least one first test photovoltaic module (2) at standard test conditions, starting from the current intensity vs. voltage curve of said first test photovoltaic module (2) at the mentioned random test conditions and starting from the estimated equivalent temperature of said at least one first test photovoltaic module (2) at the mentioned random test conditions, wherein said calculation is made by means of the following expression:

$$P_{M,C}^{*} = \frac{P_{M,C}}{P_{M,R}} \times P_{M,R}^{*} \times \frac{\left[ 1 + \gamma \times \left( T_{eq,R} - T_{eq,R}^{*} \right) \right]}{\left[ 1 + \gamma \times \left( T_{eq,C} - T_{eq,C}^{*} \right) \right]}$$

wherein $P_{M}^{*}$ is the maximum power delivered by the photovoltaic module at standard test conditions; wherein "M" indicates maximum and "*" indicates standard test conditions; and wherein the subscripts "C" and "R" indicate, respectively, the at least one first test photovoltaic module (2) and the reference photovoltaic module (1); wherein $T_{eq,R}^{*} = T_{eq,C}^{*}$, which is equal to the temperature at the standard test conditions, and wherein the gamma coefficient "$\gamma$" is the coefficient of variation of the power of the photovoltaic module with the temperature.

13. The device for estimating equivalent temperature in photovoltaic modules according to claims 11 and 12, **wherein** the processing means are configured to calculate the electrical characteristics of the at least one first test photovoltaic module (2) at standard test conditions, being based on the effective solar irradiance value associated with the estimated equivalent temperature of the test photovoltaic module (2).

FIG.1

## INTERNATIONAL SEARCH REPORT

| | International application No |
|---|---|
| | PCT/ES2019/070133 |

**A. CLASSIFICATION OF SUBJECT MATTER**
INV. H02S50/10
ADD.

According to International Patent Classification (IPC) or to both national classification and IPC

**B. FIELDS SEARCHED**

Minimum documentation searched (classification system followed by classification symbols)
H02S

Documentation searched other than minimum documentation to the extent that such documents are included in the fields searched

Electronic data base consulted during the international search (name of data base and, where practicable, search terms used)

EPO-Internal

**C. DOCUMENTS CONSIDERED TO BE RELEVANT**

| Category* | Citation of document, with indication, where appropriate, of the relevant passages | Relevant to claim No. |
|---|---|---|
| X | US 2018/034411 A1 (CHARLES NATHAN [US] ET AL) 1 February 2018 (2018-02-01) | 6-9 |
| A | paragraphs [0021] - [0058]; figures 1-5 ----- | 1-5, 10-13 |
| A | ES 2 382 796 A1 (UNIV MADRID POLITECNICA [ES]) 13 June 2012 (2012-06-13) the whole document ----- | 1-13 |

☐ Further documents are listed in the continuation of Box C.   ☒ See patent family annex.

| * Special categories of cited documents : | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 9 July 2019 | 19/07/2019 |

| Name and mailing address of the ISA/ European Patent Office, P.B. 5818 Patentlaan 2 NL - 2280 HV Rijswijk Tel. (+31-70) 340-2040, Fax: (+31-70) 340-3016 | Authorized officer Boero, Mauro |
|---|---|

Form PCT/ISA/210 (second sheet) (April 2005)

## INTERNATIONAL SEARCH REPORT
Information on patent family members

International application No

PCT/ES2019/070133

| Patent document cited in search report | Publication date | Patent family member(s) | Publication date |
|---|---|---|---|
| US 2018034411 A1 | 01-02-2018 | NONE | |
| ES 2382796 A1 | 13-06-2012 | NONE | |

Form PCT/ISA/210 (patent family annex) (April 2005)

**EP 3 764 540 A1**

**REFERENCES CITED IN THE DESCRIPTION**

**Patent documents cited in the description**

- WO 2014083212 A1